# EUROPEAN PATENT APPLICATION

(11) **EP 4 358 151 A2**
(43) Date of publication of application: **24.04.2024**
(21) Application number: 23203781.2
(22) Date of filing: 16.10.2023
(51) Int. Cl.: H01L 29/06, H01L 27/02, H01L 29/861, H01L 29/66

(54) **UNIDIRECTIONAL HIGH VOLTAGE PUNCH THROUGH TVS DIODE AND METHOD OF FABRICATION**

(30) Priority: 21.10.2022 CN 202211294947
(71) Applicant: Littelfuse Semiconductor (Wuxi) Co., Ltd., Wuxi, Jiangsu 214142 (CN)
(72) Inventor: ROSENSAFT, Boris, Wuxi, 214142 (CN); ZHOU, Jifeng, Wuxi, 214142 (CN); KELBERLAU, Ulrich, Wuxi, 214142 (CN)
(74) Representative: Arnold & Siedsma

(57) **Abstract**

A unidirectional transient voltage suppression (TVS) device. The TVS device may include a first layer, comprising an N+ material, formed on a first part of a first main surface of a substrate and a second layer formed from an N- material. The second layer may extend from a second part of the first main surface, surrounding the first layer, and may extend subjacent to the first layer. The TVS device may include a third layer, comprising a P+ material, wherein the second layer is disposed between the first layer and the third layer. The TVS device may also include an isolation region, extending from the first main surface, and being disposed around the second layer.

## Description

### Background

### Field

Embodiments relate to the field of circuit protection devices, including transient voltage suppressor devices.

### Discussion of Related Art

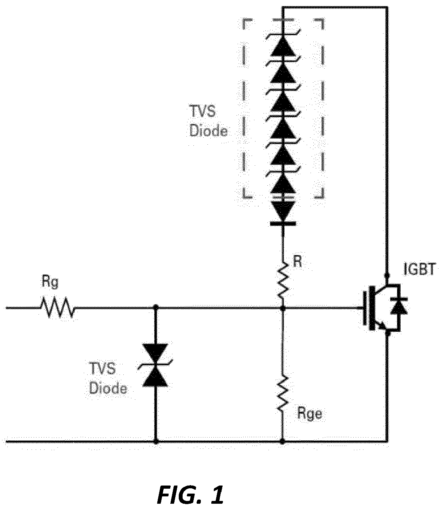

Semiconductor devices such as transient voltage suppressor (TVS) devices may be fabricated as unidirectional devices or bidirectional devices. In many applications, TVS diodes may be used to protect the sensitive circuit nodes against one-time and time-limited overvoltage faults. Such TVS diodes are also used in modern high power insulated gate bipolar transistor (IGBT) circuits to protect against overload in the collector circuit (IGBT Active Clamping, Fig. 1). The requirements for such TVS diodes may include a high breakdown voltage, with low deviation and low temperature coefficient, as well as a high surge current capability, with a low clamping voltage. TVS diodes are often arranged in series to achieve this requirement. Moreover, a Unidirectional High Voltage (HV) TVS diode requires a low deviation of breakdown voltage, which requirement is difficult to achieve using a series connection of multiple TVS diodes. Additionally, such series connection is both costly and thermally ineffective. Furthermore, a Unidirectional HV TVS diode requires a low temperature coefficient of breakdown voltage, as well as a high surge current capability, together with a low dynamic resistance in an avalanche mode to ensure the save active clamping operation.

Known NPT (Non-Punch-Through) TVS diodes used for low voltage applications may be arranged with a mesa edge termination, while low voltage punch through TVS diodes may be arranged with a trench edge termination, for example. These known low voltage TVS designs are not well suited for high voltage TVS applications, because of the resulting electric field distribution during operation. In particular, the electric filed may exhibit a maximum near a passivation region, which circumstance may cause a strong deviation of the breakdown voltage and high leakage current. Moreover, the NPT P+N-N+ in such TVS designs may lead to an increased temperature coefficient of breakdown voltage.

With respect to these and other considerations, the present disclosure is provided.

### Summary

In one embodiment, a unidirectional transient voltage suppression (TVS) device is provided. The TVS device may include a first layer, comprising an N+ material, formed on a first part of a first main surface of a substrate and a second layer formed from an N- material. The second layer may extend from a second part of the first main surface, surrounding the first layer, and may extend subjacent to the first layer. The TVS device may include a third layer, comprising a P+ material, wherein the second layer is disposed between the first layer and the third layer. The TVS device may also include an isolation region, extending from the first main surface, and being disposed around the second layer.

In another embodiment, a method of forming a unidirectional TVS device may include providing a substrate, comprising a P+ material. The method may include forming an N-layer on a surface of the substrate, wherein the N- layer comprises an N- material and wherein an outer surface of the N- layer defines a first main surface of the substrate. The method may include forming an isolation region that extends from the first main surface and surrounds the N- layer. The method may also include forming an N+ layer on a portion of the first main surface of the substrate, the N+ layer comprising an N+ material, wherein the N- layer extends around a periphery of the N+ layer and is disposed subjacent the N+ layer. As such, a P+ layer may be defined, comprising the P+ material, the P+ layer extending from a second main surface of the substrate, opposite the first main surface.

In a further embodiment, a high voltage unidirectional transient voltage suppression (TVS) device is provided. The high voltage TVS device may include a first layer, comprising an N+ material, formed on a first part of a first main surface of a P+ substrate. The high voltage TVS device may also include a second layer, formed of an N- material, where the second layer extends from a portion of the first main surface, surrounding the first layer, and extends subjacent to the first layer. As such, a third layer, comprising a P+ material, is formed, the third layer extending below the second layer to a second main surface of the P+ substrate. The high voltage TVS device may also include an N+ guard ring, extending from the first main surface, and disposed around the first layer, within the second layer, and an isolation region, extending from the first main surface, and being disposed around the second layer.

### Brief Description of the Drawings

FIG. 1 one implementation of a TVS diode arranged in a circuit with a IGBT circuit to protect against overload;
**FIG.** 2 illustrates a TVS device according to embodiments of the disclosure;
**FIG.** 3 shows an exemplary current-voltage (I-V) characteristic for a TVS device, arranged according to embodiments of the disclosure, in comparison to a reference device;
**FIG. 4A** illustrates the variation of electric field strength with effective base width W_{PT} in a TVS device;
**FIG. 4B** illustrates the variation of absolute dopant concentration with depth for the cross sections A-A and C-C of FIG. 2;
FIG. 5 illustrates a TVS device according to further embodiments of the disclosure;
**FIG.** 6 illustrates a TVS device according to additional embodiments of the disclosure; and
**FIG.** 7 presents an exemplary process flow.

### Description of Embodiments

The present embodiments will now be described more fully hereinafter with reference to the accompanying drawings, in which exemplary embodiments are shown. The embodiments are not to be construed as limited to the embodiments set forth herein. Rather, these embodiments are provided so that this disclosure will be thorough and complete, and will fully convey their scope to those skilled in the art. In the drawings, like numbers refer to like elements throughout.

In the following description and/or claims, the terms "on," "overlying," "disposed on" and "over" may be used in the following description and claims. "On," "overlying," "disposed on" and "over" may be used to indicate that two or more elements are in direct physical contact with one another. Also, the term "on,", "overlying," "disposed on," and "over", may mean that two or more elements are not in direct contact with one another. For example, "over" may mean that one element is above another element while not contacting one another and may have another element or elements in between the two elements.

The present embodiments provide an approach to generate a high voltage TVS device that is embodied in just one monolithic semiconductor die, in lieu of known high voltage TVS devices that employ a plurality of semiconductor die, electrically connected in series to one another in order to achieve a high breakdown voltage. As used herein, the term "high voltage," "high voltage TVS," and the like, may refer to devices providing breakdown voltage of 500 V or greater. As detailed below, the present embodiments feature an N+/N-/P+ structure designed as a punch through device with a top-side isolation diffusion, mesa isolation, or moat isolation, and may include N+ guard rings. This combination of the design elements provides negative dynamic resistance to the TVS device.

**FIG.** 1 illustrates one implementation of a TVS diode arranged in a circuit with a IGBT circuit to protect against overload. This arrangement shows represents a present-day arrangement that may be used for high voltage IGBT circuits for active clamping, where a series of TVS diodes are arranged in series fashion to provide a TVS device connected between the collector and gate of the IGBT shown. Thus, the TVS device may provide a high breakdown voltage in the clamping direction, by virtue of the series arrangement of individual diodes, whose individual breakdown voltage may be relatively lower, such as few hundreds of volts.

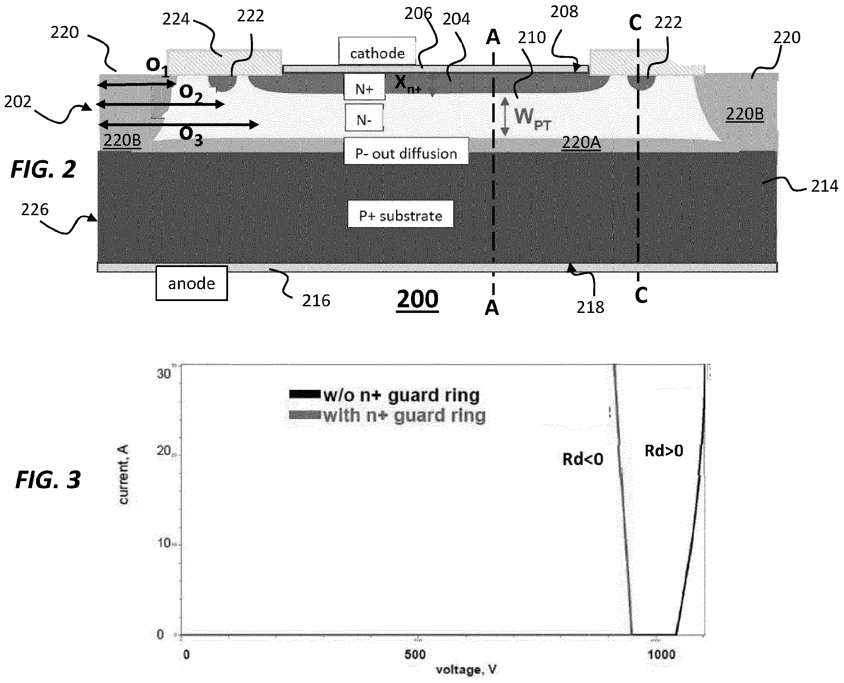

In accordance with embodiments of the disclosure FIG. 2 illustrates a unidirectional TVS device, shown as TVS device 200 that provides a high breakdown voltage within a single semiconductor die, shown as body 202. In various embodiments, the body 202 may include a P+ substrate (third layer 214), meaning that the P+ substrate is doped with a P-type dopant at a concentration of 1e18 cm⁻³ -1e21 cm⁻³. Further, the body 202 may include N- bulk (second layer 210), meaning that the N- bulk is doped with a N-type dopant at a concentration of 1e13 cm⁻³ - 5e14 cm⁻³. The TVS device 200 may include a first layer 204, comprising an N+ material, meaning that the bulk of the semiconductor die is doped with a N type dopant at a concentration of 1e18-1e21 cm⁻³. The first layer 204 is formed on a first part of a first main surface 208 of the body 202. The first layer 204 may be formed using known techniques to introduce an N-type dopant into a N- bulk (second layer 210), such as ion implantation, deposition in a dopant atmosphere, and so forth. As illustrated, the first layer 204 is formed within a region that is defined by a passivation structure 224, disposed on the first main surface 208. In various non-limiting embodiments, the depth of the N+ layer, first layer 204, may range from 10 µm to 50 µm.

As shown in FIG. 2, the first layer 204 is formed with a second layer 210, which layer extends from a second portion of the first main surface 208 and surrounds the first layer 204. In particular, the second layer 210 also extends subjacent to the first layer 204. The second layer may be formed of an N- material, meaning that the bulk of the semiconductor die is doped with a N-type dopant at a concentration of a range from 1e13 cm⁻³ to 5e14 cm⁻³. In any case, the N-type dopant concentration of the second layer 210 will generally be times less than the N-type dopant concentration of the first layer 204.

As further illustrated in FIG. 2, the TVS device 200 may include a third layer 214, comprising a P+ material, where the second layer 210 is disposed between the first layer 204 and the third layer 214. The second layer 210 (N- bulk) may be grown on the third layer 214, which concentration may have range from 1e18 cm⁻³ to 1e21 cm⁻³. Note that in some embodiments, the second layer 210 (Layer N-) may be formed by epitaxy process on a P+ substrate, where the doping concentration of the P+ substrate may be in the range from 1e18 cm⁻³ to 1e21 cm⁻³.

The TVS device 200 may further include an isolation region 220, extending from the first main surface 208. In this example, the isolation region 220 is disposed around the second layer 210 and extends to a side surface 226 of the body 202. In the particular embodiment illustrated in FIG. 2, the isolation region 220 is formed of a P- outdiffusion region 220B that extends around a periphery of the second layer 210. Note that the isolation region 220 may be a parasitic layer, which layer is formed during isolation diffusion process. The lower the depth of the p- layer the more precise may be the breakdown voltage of the device.

In addition, an outdiffusion layer 220A, comprising a P- material, may form between the third layer 214 and the second layer 210.

As further shown in FIG. 2, the TVS device 200 may include an N+ guard ring 222, extending from the first main surface 208, and disposed around the first layer 204, within the second layer 210. The TVS device 200 may further include a top contact 206 (electrical contact such as a metal contact) and bottom contact 216 (metal contact) as shown, disposed on second main surface 218, within a contact region defined by the passivation structure 224.

As noted the N- layer (second layer 210) may be grown on a P+ substrate (third layer 214). According to various non-limiting embodiments, the initial thickness of the second layer 210 may be in the range of 50 µm to 100 µm. A next operation may be performed to introduce P-type dopant into the regions of the first main surface 208, so as to form the isolation region 220. Note that the isolation region 220 may be formed in regions of the N- bulk that previously included the second layer 210. Patterning of the first main surface 208 may subsequently be performed to define regions to introduce further N-type dopant into the N- layer (second layer 210), via the first main surface 208, so as to form the first layer 204 and N+ guard ring 222.

By choosing suitable dimensions and dopant concentration for the first layer, second layer, third layer, N+ guard ring, a novel device may be engineered to provide a punch-through N+N-P+ structure with an isolation diffusion edge termination in a monolithic device for the purpose of high voltage TVS applications. Returning to FIG. 2 there are shown a set of designed offsets from the side surface 226 for the passivation structure 224 (O₁), the N+ guard ring 222 (O₂), and the first layer 204 (O₃). In one non-limiting example O₁ may equal 150 µm, O₂ may equal 450 µm, and O₃ may equal 550 µm.

Turning now to FIG. 3, in the simulated reverse I-V curves shown, the active clamping function of the TVS device 200 corresponds to the reverse blocking direction ("+" on cathode and "-" on anode). In this example, the right curve corresponds to the I-V behavior of the TVS device in the absence of the N+ guard ring 222, while the left curve corresponds to the I-V behavior of the TVS device in the presence of the N+ guard ring 222. The provision of Patterned N+ emitter (first layer 204) and N+ guard rings 222 ensures a high voltage range of operation of the TVS device 200. The punch through design of TVS device 200 makes possible a low deviation in the breakdown voltage, because the breakdown voltage primarily depends on the effective width of base **W_{PT}** as defined in FIG. 2, while other design parameters such as the resistivity of the N-layer (second layer 210) have a low influence on the breakdown voltage. Moreover, the use of the N+N-P+ punch through structure of TVS device 200 provides other important advantages, including low power losses during a surge current event, as well as a low temperature coefficient of the breakdown voltage. The former advantage is caused by negative dynamic resistance in avalanche mode (see left curve of FIG. 3).

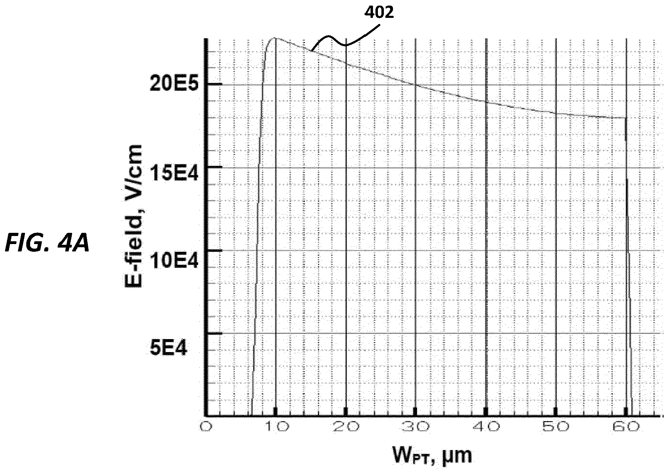

Turning to **FIG. 4A** there is shown the variation of electric field strength with effective base width W_{PT} in avalanche mode in an example of TVS device 200, as generally arranged according to FIG. 2. As illustrated, the curve 402 generally describes a trapezoid shape. For the example shown, the maximum in field strength occurs at a value of approximately 10 µm, while slowly decreasing with increased value of W_{PT} up to 60 µm, before falling toward zero. As best understood, it is this trapezoidal E-field distribution that results in the low temperature coefficient of the breakdown voltage afforded by the TVS device 200.

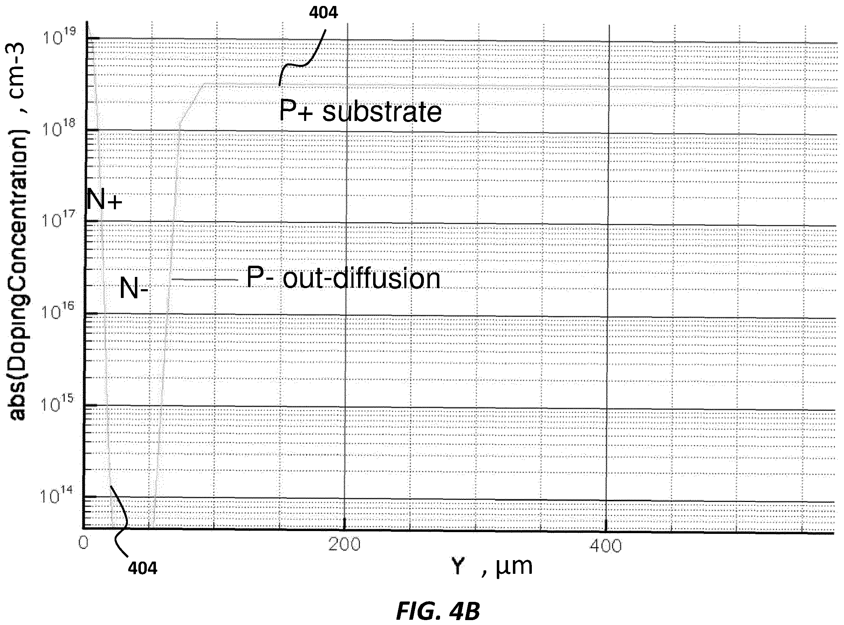

**FIG. 4B** illustrates the variation of absolute dopant concentration with depth for the cross sections A-A and C-C, in accordance with a variant of the TVS device 200 of FIG. 2, while FIG. 4C illustrates the variation of absolute dopant concentration with depth for the cross sections B-B and C-C of FIG. 2. In the example of FIG. 4B, the curve 404 describes a peak concentration of dopant near 2E19/cm² that corresponds to the maximum doping level of the N+ region of first layer 204 (emitter) or N+ guard ring 222. The regions between 25 µm depth and 50 µm depth of so corresponds to the N- region of second layer 210, while the region at depths of 80 µm or greater corresponds to the P+ substrate (third layer 214). In this example, the P+ substrate has a dopant concentration of 3E18/cm³.

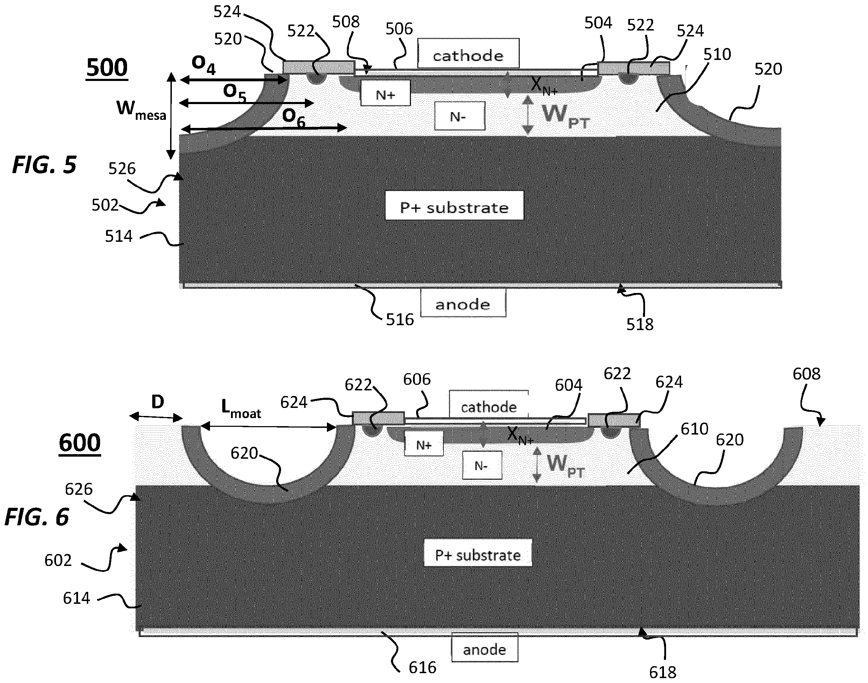

**FIG.** 5 illustrates a TVS device 500 according to further embodiments of the disclosure. As with the embodiments of FIG. 2, the TVS device 500 illustrates a unidirectional TVS device that provides a high breakdown voltage within a single semiconductor die, shown as body 502. In various embodiments, the body 502 may include a P+ substrate, as discussed above with respect to FIG. 2. The TVS device 500 may include a first layer 504, comprising an N+ material, as discussed previously. The first layer 504 is formed on a first part of a first main surface 508 of the body 502.

According to different embodiments of the disclosure, the first layer 504 may be created by ion implantation or diffusion of donors in an N- layer. The depth of the first layer 504 is shown as Xn+)̵ meaning a depth of the N+ doping profile. In various embodiments,

As illustrated, the first layer 504 is formed generally within a region that is surrounded by a passivation structure 524, disposed on the first main surface 508, which passivation structure may be used to define a top contact 506. In various non-limiting embodiments, the depth of the N+ layer, Xₙ₊ of first layer 504, may range from 10 µm to 50 µm.

Similarly to the embodiment of FIG. 2, and as shown in FIG. 5, the first layer 504 is formed with a second layer 510, which layer extends from a second portion of the first main surface 508 and surrounds the first layer 504. In particular, the second layer 510 also extends subjacent to the first layer 504. The second layer 510 may be an N- layer, formed of an N- material, as discussed previously with respect to FIG. 2.

As further illustrated in FIG. 5, the TVS device 500 may include a third layer 514, comprising a P+ material, where the second layer 510 is disposed between the first layer 504 and the third layer 514. The third layer 514 may be a part of the body 502 as discussed previously.

The TVS device 500 may further include an isolation region 520, extending from the first main surface 508. In this example, the isolation region 520 is disposed around the second layer 510 and extends to a side surface 526 of the body 502. In the particular embodiment illustrated in FIG. 5, the isolation region 520 is formed of a mesa structure that extends around a periphery of the second layer 510. The mesa structure may be formed using known methods, including lithography, etching and passivation, for example, to form an passivation material that acts as an electrical insulator. The depth of the mesa shown as Wₘₑₛₐ, the dimension of this entity may generally be determined as W_{MESA}=X_{N+}+W_{PT}+10µm to 30µm. Thus, the mesa structure extends into the third layer 514, beyond second layer 510.

As further shown in FIG. 5, the TVS device 500 may include an N+ guard ring 522, extending from the first main surface 508, and disposed around the first layer 504, within the second layer 510. The TVS device 500 may further include a top contact 506 (metal contact) and bottom contact 516 as shown, disposed on second main surface 518. FIG. 5 further provides a set of designed offsets from the side surface 526 for the passivation structure 524 (O₄), the N+ guard ring 522 (O₅), and the first layer 504 (O₃). In one non-limiting example O₁ may equal 400 µm, O₂ may equal 700 µm, and O₃ may equal 800 µm.

As with the embodiment of FIG. 2, the punch through design of TVS device 500 makes possible a low deviation in the breakdown voltage, because the breakdown voltage depends primarily on the effective width of base **W_{PT}.** Moreover, the use of the N+N-P+ punch through structure of TVS device 500 provides for low power losses during a surge current event, as well as a low temperature coefficient of the breakdown voltage, as discussed with respect to the TVS device 200.

An advantage of the design of the embodiment of FIG. 5 with respect to TVS device 200 is that the use of mesa isolation does not employ a diffusion isolation process and does not therefore introduce a P- layer such as a lower outdiffusion layer, shown as layer outdiffusion 220A . Accordingly, the effective width of base W_{PT} may be more precisely defined between the first layer 504 and the bottom of the second layer 510. Said differently, because there is significantly lower P- out-diffusion during formation of first layer 504, N+ guard rings 522 and the moat structure of isolation region 520, control of the value of W_{PT} is better, which control consequently causes a lower deviation (variation) of breakdown voltage. The deviation in breakdown voltage means the variation of breakdown voltage between different devices for nominally the same process (e. g. within a wafer, batch to batch or wafer to wafer deviation).

**FIG.** 6 illustrates a TVS device according to additional embodiments of the disclosure. As with the embodiments of FIG. 2, the TVS device 600 illustrates a unidirectional TVS device that provides a high breakdown voltage within a single semiconductor die, shown as body 602. In various embodiments, the body 602 may include a P+ substrate, as discussed above with respect to FIG. 2. The TVS device 600 may include a first layer 604, comprising an N+ material, as discussed previously. The first layer 604 is formed on a first part of a first main surface 608 of the body 602. As illustrated, the first layer 604 is formed generally within a region that is surrounded by a passivation structure 624, disposed on the first main surface 608, which passivation structure may be used to define a top contact 606. In various non-limiting embodiments, the depth of the N+ layer, first layer 604, may range from 10 µm to 50 µm.

Similarly to the embodiments of FIG. 2 and FIG. 5, and as shown in FIG. 6, the first layer 604 is formed with a second layer 610, which layer extends from a second portion of the first main surface 608 and surrounds the first layer 604. In particular, the second layer 610 also extends subjacent to the first layer 604. The second layer 610 may be formed of an N-material, as discussed previously with respect to FIG. 2.

As further illustrated in FIG. 6, the TVS device 600 may include a third layer 614, comprising a P+ material, where the second layer 610 is disposed between the first layer 604 and the third layer 614. The third layer 614 may be a part of the body 602 as discussed previously with respect to FIG. 2.

The TVS device 600 may further include an isolation region 620, extending from the first main surface 608. In this example, the isolation region 620 is disposed around the second layer 610 and extends to a side surface 626 of the body 602. In the particular embodiment illustrated in FIG. 6, the isolation region 620 is formed of a moat structure that extends around a periphery of the second layer 610. The mesa structure may be formed using known methods, including lithography, etching and passivation, for example, to form an oxide material that acts as an electrical insulator. The width of the moat shown as Lₘₒₐₜ, may be between 400 µm to 600 µm according to various non-limiting embodiments. In addition, the moat structure extends to a depth sufficient to enter into the third layer 614, beyond second layer 610. Moreover, an offset D of the isolation region 620 from the side surface 626 may be a range of 50 µm to 200 µm in various non-limiting embodiments.

As further shown in FIG. 6, the TVS device 600 may include an N+ guard ring 622, extending from the first main surface 608, and disposed around the first layer 604, within the second layer 610. The TVS device 600 may further include a top contact 606 (metal contact) and bottom contact 616, disposed on second main surface 618 as shown.

As with the embodiment of FIG. 2 and FIG. 5, the punch through design of TVS device 600 makes possible a low deviation in the breakdown voltage, because the breakdown voltage primarily depends primarily on the effective width of base W_{PT}. Moreover, the use of the N+N-P+ punch through structure of TVS device 600 provides for low power losses during a surge current event, as well as a low temperature coefficient of the breakdown voltage, as discussed with respect to the TVS device 200.

An advantage of the design of the embodiment of FIG. 6 with respect to TVS device 200 is that the use of moat isolation does not employ a diffusion isolation process and does not therefore introduce a P- layer such as outdiffusion layer 220A. Accordingly, the effective width of base W_{PT} may be more precisely defined between the first layer 604 and the bottom of the second layer 510. Said differently, because there is significantly lower P- out-diffusion during formation of first layer 604 , N+ guard rings 522 and the moat structure of isolation region 620, control of the value of W_{PT} is better, which control consequently causes a lower deviation (variation) of breakdown voltage. A further advantage is that the moat structure does not intersect the side surface 626. In other words, since the side surface 626 may be formed by dicing a semiconductor wafer, the dicing process is located well away from any passivation area of the moat structure, thus avoiding defects that may be introduced when cutting through passivation.

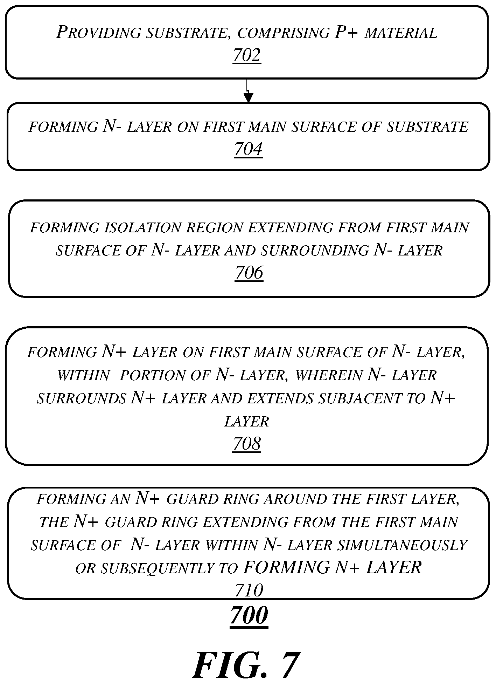

**FIG.** 7 presents an exemplary process flow 700. At block 702 a substrate is provided, where the substrate is formed of a P+ material, meaning the substrate is a semiconductor material that is doped with a P-type dopant at a concentration in a suitable range. In some embodiments, this range is between of 1e18 cm⁻³ to 1e21 cm⁻³.

At block 704, an N- layer is formed on a first main surface of the P+ substrate. The N- layer may have an N-type dopant concentration in a suitable range. As such, after formation of the N- layer, the outer surface of the N- layer will correspond to the first main surface. In some embodiments, this range is between 1e13 cm⁻³ to 5e14 cm⁻³. As such, a P-type region that defines a P+ layer may extend from the second main surface of the substrate P+ up to a boundary of the N- layer.

At block 706, an isolation region is formed that extends from the first main surface of N- layer and surrounds the N- layer. In various embodiments, the isolation region may be formed of a P- isolation diffusion structure, a mesa structure, or a moat structure. The isolation region may extend through an entirety of the N- layer and into the P+ layer.

At block 708, an N+ layer is formed on the first main surface of the N- layer, within a portion of the N- layer, wherein N- layer surrounds the N+ layer and extends subjacent to N+ layer. As such, the combination of the N+ layer, N- layer, and P+ layer may define a punch through structure.

At block 710, an N+ guard ring is formed around the first layer, wherein the N+ guard ring extends from the first main surface (meaning the outer surface of the N- layer) within the N- layer. N+ guard ring may be formed simultaneously or subsequently to the forming N+ layer.

In sum, the present embodiments provide at least the following advantages. As a first matter, a unidirectional TVS is realized in a single monolithic substate that supports high voltages (500 V) or greater. More particularly, a N+NP+ Punch-Through structure is provided having a top-sided isolation diffusion edge termination in monolithic HV (>500V) TVS device. Moreover, in some embodiments a punch through N+N-P+ structure with front-sided simple mesa or moat termination is realized in a monolithic HV (>500V) TVS device.

While the present embodiments have been disclosed with reference to certain embodiments, numerous modifications, alterations and changes to the described embodiments are possible while not departing from the sphere and scope of the present disclosure, as defined in the appended claims. Accordingly, the present embodiments are not to be limited to the described embodiments, and may have the full scope defined by the language of the following claims, and equivalents thereof.

## Claims

1. A unidirectional transient voltage suppression (TVS) device, comprising:
a first layer, comprising an N+ material, formed on a first part of a first main surface of a substrate;
a second layer, extending from a second part of the first main surface, surrounding the first layer, and extending subjacent to the first layer, the second layer comprising an N- material;
a third layer, comprising a P+ material, wherein the second layer is disposed between the first layer and the third layer; and
an isolation region, extending from the first main surface, and being disposed around the second layer.

2. The unidirectional TVS device of claim 1, wherein the substrate comprises a P+ substrate, wherein the third layer extends from a second main surface of the substrate, opposite the first main surface.

3. The unidirectional TVS device of claim 1 or 2, wherein the isolation region comprises a P-outdiffusion region, wherein an outer portion of the isolation region extends around a periphery of the second layer, and wherein a lower outdiffusion region comprising a P- material is disposed between the third layer and the second layer.

4. The unidirectional TVS device of any of the preceding claims, further comprising an N+ guard ring, extending from the first main surface, and disposed around the first layer, within the second layer.

5. The unidirectional TVS device of any of the preceding claims, further comprising a passivation structure, disposed on the first main surface, and extending over at least a portion of the isolation region, the second layer, the guard ring, and the first layer.

6. The unidirectional TVS device of any of the preceding claims, comprising one or more of the following:
wherein the isolation region comprises a mesa structure, the mesa structure extending through the second layer and into the third layer, and wherein the second layer is disposed directly adjacent to the third layer;
wherein the isolation region comprises a moat structure, the moat structure extending through the second layer and into the third layer, and wherein the second layer is disposed directly adjacent to the third layer;
wherein the substrate defines a set of side surfaces, and wherein the moat structure does not intersect the set of side surfaces.

7. A method of forming a unidirectional TVS device, comprising:
providing a substrate, comprising a P+ material;
forming an N- layer on a surface of the substrate, wherein the N- layer comprises an N-material and wherein an outer surface of the N- layer defines a first main surface of the substrate;
forming an isolation region that extends from the first main surface and surrounds the N-layer; and
forming an N+ layer on a portion of the first main surface of the substrate, the N+ layer comprising an N+ material, wherein the N- layer extends around a periphery of the N+ layer and is disposed subjacent the N+ layer, and wherein a P+ layer is defined, comprising the P+ material, the P+ layer extending from a second main surface of the substrate, opposite the first main surface.

8. The method of claim 7, comprising one or more of the following:
wherein the forming the N+ layer takes place after the forming the N- layer;
wherein the isolation region comprises a P- outdiffusion region that is formed by diffusing a P type dopant into a portion of the first main surface, wherein an outer portion of the isolation region extends around a periphery of the N- layer, and wherein a lower outdiffusion region comprising a P- material is disposed between the P+ layer and the N- layer;
forming an N+ guard ring around the N+ layer, the N+ guard ring extending from the first main surface within the N- layer.

9. The method of claims 7 or 8, further comprising forming a passivation structure over a portion of the first main surface, the passivation structure defining a contact region, disposed over the N+ layer, the method further comprising forming an electrical contact within the contact region.

10. The method of any of the claims 7-9, wherein the forming the isolation region comprises forming a mesa structure, the mesa structure extending through the N- layer and into the P+ layer, and wherein the N- layer is disposed directly adjacent to the P+ layer.

11. The method of any of the claims 7-10, wherein the forming the isolation region comprises forming a moat structure, the moat structure extending through the N- layer and into the P+ layer, and wherein the N- layer is disposed directly adjacent to the P+ layer.

12. The method of any of the claims 7-11, wherein the substrate defines a set of side surfaces, and wherein the moat structure does not intersect the set of side surfaces.

13. A high voltage unidirectional transient voltage suppression (TVS) device, comprising:
a first layer, comprising an N+ material, formed on a first part of a first main surface of a P+ substrate;
a second layer, extending from a portion of the first main surface, surrounding the first layer, and extending subjacent to the first layer, the second layer comprising an N- material, wherein a third layer, comprising a P+ material, is formed, the third layer extending below the second layer to a second main surface of the P+ substrate;
an N+ guard ring, extending from the first main surface, and disposed around the first layer, within the second layer; and
an isolation region, extending from the first main surface, and being disposed around the second layer.

14. The high voltage unidirectional TVS device of claim 13, wherein the isolation region comprises a P- outdiffusion region, wherein an outer portion of the isolation region extends around a periphery of the second layer, and wherein a lower outdiffusion region comprising a P- material is disposed between the third layer and the second layer.

15. The high voltage unidirectional TVS device of claim 13 or 14, further comprising a passivation structure, disposed on the first main surface, and extending over at least a portion of the isolation region, the second layer, the guard ring, and the first layer,
and/or
wherein the isolation region comprises a mesa or a moat structure, the isolation region extending through the second layer and into the third layer, and wherein the second layer is disposed directly adjacent to the third layer.
